Europäisches Patentamt

European Patent Office

Office européen des brevets

(19)

(11) Numéro de publication: **0 243 231 B1**

# FASCICULE DE BREVET EUROPEEN

(12)

(45) Date de publication de fascicule du brevet:
**17.07.91**

(51) Int. Cl.⁵: **C30B 15/00,** C30B 11/00,
C30B 29/40

(21) Numéro de dépôt: **87400757.8**

(22) Date de dépôt: **06.04.87**

(54) **Procédé de préparation de semi-isolants 3-5-mono-cristallins par dopage et application des semi-isolants ainsi obtenus.**

(30) Priorité: **08.04.86 FR 8605000**

(43) Date de publication de la demande:
**28.10.87 Bulletin 87/44**

(45) Mention de la délivrance du brevet:
**17.07.91 Bulletin 91/29**

(84) Etats contractants désignés:
**BE CH DE ES GB IT LI NL**

(56) Documents cités:
**FR-A- 1 409 116**
**GB-A- 1 339 564**

(73) Titulaire: **ETAT FRANCAIS représenté par le Ministre des PTT (Centre National d'Etudes des Télécommunications)**
**38-40 rue du Général Leclerc**
**F-92131 Issy-les-Moulineaux(FR)**

(72) Inventeur: **Lambert, Bertrand**
**Rue des Sept Tournants "Le Petit Chêne" Brélévenez**
**F-22300 Lannion(FR)**
Inventeur: **Toudic, Yves**
**4, rue des Blés d'Or Bloubezre**
**F-22300 Lannion(FR)**
Inventeur: **Coquille, René**
**8, cité Kerléon**
**F-22660 Trelevern(FR)**

(74) Mandataire: **Warcoin, Jacques et al**
**Cabinet Régimbeau 26, avenue Kléber**
**F-75116 Paris(FR)**

EP 0 243 231 B1

## Description

La présente invention concerne un procédé de préparation de semi-isolants 3-5 mono-cristallins par dopage et l'application des semi-isolants ainsi obtenus.

Dans le domaine des semi-conducteurs, il est connu de réaliser des mono-cristaux, par croissance à partir d'un germe, selon les méthodes connues de tirage LEC, ou de croissance Bridgman.

GB-A-1 339 564 décrit un procédé de préparation de semi-isolants 3-5 qui comprend le dopage d'une charge InP ou d'un alliage Inp + GaP avec du chrome. Toutefois, dans cette demande de brevet, il n'est pas fait recours au niveau donneur profond du chrome responsable des propriétés semi-isolantes.

Dans FR-A1 409 116, il est décrit un procédé de croissance d'un monocristal à haute résistivité de GaAs, le cristal étant dopé avec du chrome. Les propriétés semi-isolantes sont obtenues par compensation des impuretés résiduelles de type donneur (type n) par un accepteur profond, en l'occurence le chrome.

De nombreux problèmes se posent cependant, pour la réalisation de substrats semi-isolants (s-i). En effet, les dopants proposés jusqu'à présent ne se sont pas révélés satisfaisants, du fait en particulier de la valeur de leur coefficient de diffusion. Il en est ainsi pour E.L.2 "electron level no.2" dans le cas de GaAs, et de Fe dans le cas de InP.

Ces problèmes sont résolus selon l'invention par la réalisation d'un dopage avec au moins un donneur profond. Le procédé selon l'invention permet la réalisation de semi-isolants aussi bien à partir d'une charge de départ de type p que de type n.

Ainsi, la présente invention concerne un procédé de préparation de semi-isolants 3-5 monocristallins par dopage, caractérisé en ce que l'on dope une charge de type p avec au moins un donneur profond dû à un élément de transition.

Un composé binaire de type p classique est GaAs ; les échantillons de GaAs non dopés sont résiduels de type p, obtenus en tirage. Un dopage de tels échantillons par un donneur profond permet de compenser ces échantillons de type p et de les rendre semi-isolants.

Parmi les métaux de transition 3d, selon l'invention, on préfère utiliser pour ce dopage, le titane et/ou le chrome, qui donnent des niveaux donneurs profonds.

Ainsi, on a réalisé le dopage et fait croître des échantillons de GaAs s-i dopés avec du Cr ou du Ti.

Dans le cas le plus fréquemment rencontré, où l'échantillon est de type n résiduel - c'est le cas par exemple d'échantillons InP - selon l'invention, on dope en outre la charge de départ et/ou le monocristal, précédemment dopé avec un donneur profond, avec au moins un accepteur. Ce co-dopage permet de rendre de type p un échantillon à l'origine de type n, par un dopage approprié en accepteur. Le cristal de type n, rendu de type p par dopage, sera rendu semi-isolant par l'introduction d'au moins un deuxième dopant, donneur profond.

Ainsi, selon la présente invention, lorsque la charge de départ est de type n, elle est préalablement rendue de type p par dopage avec au moins un accepteur.

Cette méthode de co-dopage est particulièrement intéressante dans le cas de InP, bien que l'on puisse réaliser par cette méthode des semi-isolants 3-5 à partir d'autres substrats binaires.

Comme accepteur selon l'invention, on peut envisager tout accepteur ayant un coefficient de ségrégation acceptable, une solubilité limite dans le substrat convenable et une bonne stabilité thermique. Les accepteurs cadmium et mercure conviennent particulièrement. Les trous qui proviennent du dopage par cet accepteur sont piégés par le donneur profond, par exemple Cr ou Ti.

Ainsi, on a réalisé le co-dopage et fait croître des échantillons de InP si co-dopés avec Cd-Cr, Hg-Cr, Hg-Ti ou Cd-Ti.

Ainsi, un bain de départ résiduel de type n ($N_D$ - $N_A \simeq 5.10^5$ cm$^{-3}$) dopé par un accepteur (Cd ou Hg), à une concentration un peu supérieure ($10^{16}$cm$^{-3}$ par exemple) sera rendu semi-isolant par un co-dopant donneur profond (Ti ou Cr), en quantité suffisante pour compenser les accepteurs.

Afin de garantir la constance de la résistivité entre la tête et la queue du monocristal lors de la croissance, il faut tenir compte des coefficients de ségrégation des dopants pour prévoir leurs concentrations dans le bain.

Pour Hg, la Demanderesse a pu mettre en évidence un coefficient de ségrégation voisin de 1. De mêmepour l'accepteur Cd, le coefficient de ségrégation est voisin de 1, de l'ordre de 0,5. Dans le cas d'un dopage avec ces deux accepteurs, le dopage est pratiquement identique en tête et queue du cristal, ainsi que dans le bain de départ, soit environ $10^{16}$ cm$^{-3}$.

Par contre, le donneur chrome a un coefficient de ségrégation de l'ordre de $3.10^{-4}$; on ajoute le chrome à une concentration de $10^{16}$, soit $3,3.10^{19}$ dans le bain de départ, et le dopage en Cr va croissant, la résistivité va en augmentant de la tête vers la queue du cristal.

Pour réaliser de tels cristaux, on utilise les méthodes classiques de croissance, en particulier la méthode de tirage LEC et la méthode Bridgman.

Quand on emploie la méthode LEC, dans le cas du co-dopage de InP en particulier, les impuretés dopantes sont introduites en général en même temps que la charge de départ sous forme de chrome, de titane, de cadmium ou de mercure introduit dans le bain de départ avant le tirage. Mais les impuretés dopantes trop volatiles ne peuvent être introduites lors du tirage.

On peut alors en outre introduire les impuretés dopantes comme Hg ou Cd dans la charge de départ elle-même, en utilisant un polycristal prédopé par l'une des impuretés dopantes.

Les semi-isolants obtenus sont notamment utiles dans les domaines de l'optoélectronique et de l'électronique rapide. Ils permettent en particulier de fabriquer des substrats pour l'épitaxie. C'est pourquoi, la présente invention concerne l'utilisation des semi-isolants préparés selon l'invention dans ces domaines.

D'autres avantages et caractéristiques de l'invention apparaîtront à la lecture des exemples ci-après.

Exemple 1

Co-dopage cadmium-chrome sur InP.

On a réalisé des cristaux en InP co-dopé par Cd-Cr par la méthode de tirage LEC (tirage Czochralski sous encapsulation liquide). A une charge d'InP polycristalline de 496 g, ayant une concentration résiduelle $N_D-N_A$ de 5 à $7.10^{15}$ cm$^{-3}$, on a ajouté 277 mg de chrome. On dispose dans un creuset en silice ou en PBN la charge polycristalline d'InP, le chrome et 10 g d'InP fortement dopé au cadmium ($1,5.10^{18}$ atomes cm$^{-3}$) puis le disque de $B_2O_3$ (encapsulant liquide).

On chauffe l'ensemble dans l'enceinte de tirage, sous une pression de 50 bars d'azote, jusqu'à la fusion de InP (1063°C).

On effectue alors le tirage à une vitesse d'environ 1,5 cm/h suivant la direction <001>.

Le cristal obtenu est semi-isolant, il présente les caractéristiques électriques suivantes :
$\rho = 10^4 \Omega$cm à 400K.

Exemple 2

Co-dopage mercure-titane sur InP.

Selon la même méthode qu'à l'exemple 1, on a réalisé des cristaux de InP co-dopé par Hg-Ti.

La charge de départ consiste en 500 g d'une charge polycristalline d'InP déjà dopé au mercure ($10^{16}$ atomes cm$^{-3}$) à laquelle on a ajouté 250 mg de titane.

Le cristal est tiré suivant la direction <001>.

Le cristal obtenu possède la résistivité suivante :

$\rho = 3,8\ 10^2 \Omega$cm à 400K.

## Revendications

1. Procédé de préparation de semi-isolant 3-5 monocristallin par dopage, caractérisé en ce que l'on dope une charge de type p avec au moins un donneur profond dû à un élément de transition.

2. Procédé selon la revendication 1, caractérisé en ce que lorsque la charge de départ est de type n, elle est préalablement rendue de type p par dopage avec au moins un accepteur.

3. Procédé selon la revendication 1 ou 2, caractérisé en ce que la charge de départ comprend GaAs ou InP.

4. Procédé selon l'une des revendications 1 à 2, caractérisé en ce que les donneurs profonds sont choisis parmi Ti et/ou Cr.

5. Procédé selon l'une des revendications 2 à 4, caractérisé en ce que les accepteurs sont choisis parmi Cd et/ou Hg.

6. Procédé selon les revendications 2 à 5, caractérisé en ce qu'une charge de départ InP est co-dopée par Cd ou Hg et Cr.

7. Procédé selon les revendications 2 à 5, caractérisé en ce qu'une charge de départ InP est codopée par Cd ou Hg et Ti.

8. Utilisation des semi-isolants obtenus par le procédé selon l'une des revendications 1 à 7, dans les domaines de l'optoélectronique et de l'électronique rapide.

## Claims

1. A process for the preparation by doping of monocrystalline semi-insulant III-V materials, characterised in that a type p charge is doped with at least one deep donor due to a transition element.

2. A process according to claim 1, characterised in that when the initial charge is type n it is first converted into type p by doping with at least one acceptor.

3. A process according to claim 1 or 2, characterised in that the initial charge comprises GaAs or InP.

4. A process according to claim 1 and/or 2, characterised in that the deep donors are chosen among Ti and/or Cr.

5. A process according to any of claims 2 to 4, characterised in that the acceptors are chosen among Cd and/or Hg.

6. A process according to claims 2 to 5, characterised in that the initial InP charge is codoped with Cd or Hg and Cr.

7. A process according to claims 2 to 5, characterised in that an initial InP charge is codoped with Cd or Hg and Ti.

8. Use of the semi-insulant prepared by the process according to any of claims 1 to 7 in electron optics and fast electronics.

**Patentansprüche**

1. Verfahren zur Herstellung von einkristallinen III-V Semi-Isolatoren durch Dotierung, **dadurch gekennzeichnet, daß** man eine p-Typ-Ladung mit wenigstens einem auf einem Übergangselement beruhenden Tiefendonator dotiert.

2. Verfahren nach Anspruch 1, dadurch gekennzeichnet, daß dann, wenn die Ausgangsladung vom n-Typ ist, sie vorher durch Dotierung mit wenigstens einem Akzeptor zum p-Typ gemacht wird.

3. Verfahren nach Anspruch 1 oder 2, dadurch gekennzeichnet, daß die Ausgangsladung GaAs oder InP umfaßt.

4. Verfahren nach einem der Ansprüche 1 bis 2, dadurch gekennzeichnet, daß die Tiefendonatoren unter Ti und/oder Cr ausgewählt werden.

5. Verfahren nach einem der Ansprüche 2 bis 4, dadurch gekennzeichnet, daß die Akzeptoren unter Cd und/oder Hg ausgewählt werden.

6. Verfahren nach den Ansprüchen 2 bis 5, dadurch gekennzeichnet, daß eine Ausgangsladung InP mit Cd oder Hg und Cr codotiert wird.

7. Verfahren nach den Ansprüchen 2 bis 5, dadurch gekennzeichnet, daß eine Ausgangsladung InP mit Cd oder Hg und Ti codotiert wird.

8. Verwendung der nach den Verfahren nach einem der Ansprüche 1 bis 7 erhaltenen Semi-Isolatoren in den Gebieten der Optoelektronik und Hochleistungselektronik.